# EUROPÄISCHE PATENTSCHRIFT

(11) **EP 3 911 137 B1**
(45) Veröffentlichungstag und Bekanntmachung des Hinweises auf die Patenterteilung: **04.10.2023**
(21) Anmeldenummer: 21172672.4
(22) Anmeldetag: 07.05.2021
(51) Int. Cl.: H05K 9/00

(54) **SCHALTSCHRANK MIT VON HOCHFREQUENZ-ABSORBIERENDER FOLIE BEDECKTER SEITENWAND**
SWITCH CABINET WITH SIDEWALL COVERED BY HIGH FREQUENCY-ABSORBING FILM
ARMOIRE DE COMMANDE POURVU DE PAROI LATÉRALE COUVERT PAR UNE FEUILLE ABSORBANT LES HAUTES FRÉQUENCES

(30) Priorität: 13.05.2020 DE 102020112939
(43) Veröffentlichungstag der Anmeldung: 17.11.2021
(73) Patentinhaber: Rittal GmbH & Co. KG, 35745 Herborn (DE)
(72) Erfinder: Holighaus, Heiko, 35713 Eschenburg (DE); Lohrey, Hartmut, 35410 Hungen (DE); Rathenow, Sven, 35398 Gießen (DE); Gräbner, Frank, 99734 Nordhausen (DE)
(74) Vertreter: Angerhausen, Christoph

(56) Entgegenhaltungen:
- EP-A1- 0 818 126
- EP-A1- 2 787 803
- EP-A1- 3 598 862
- DE-A1- 19 856 776
- KR-A- 20130 009 532

## Beschreibung

Die Erfindung geht aus von einem Schaltschrank mit einer Mehrzahl Rahmenprofile, durch die äußere Vertikalebenen festgelegt sind, wobei in mindestens einer der Vertikalebenen mindestens eine Seitenwand des Schaltschranks angeordnet ist. Ein Schaltschrank in diesem Sinne kann beispielsweise ein IT-Gehäuse, ein Serverrack oder ein Kleingehäuse sein.

Ein derartiger Schaltschrank ist aus der DE 10 2015 121193 B4 bekannt. Aus der DE 198 56 776 A1 ist ferner ein Schaltschrank bekannt, welcher als Schutzeinrichtung gegen elektromagnetische Strahlung mehrere Folienstücke aufweist, die elektrisch leitend miteinander verbunden sind. Ferner ist die Folie im Sinne der Erfindung ein Foliensystem bestehend aus zumindest zwei Lagen. Folien, welche Zwecks der Absorption von elektromagnetischen Wellen magnetische Partikel aufweisen sind beispielsweise aus der KR 10 2013 0 009 532 A oder der US 2020 /0 008 328 A1 bekannt. Darüber hinaus werden weitere elektromagnetische Strahlung absorbierende Folien in der EP 3 598 862 A1 und EP 3 598 862 A1 beschrieben.

Die stetige Zunahme elektronischer Geräte in allen technischen Gebieten wie beispielsweise Mobilfunk, PC-Technik oder Bahnelektronik bringt die Problematik mit sich, dass immer mehr hochfrequente elektromagnetische Felder vorhanden sind, welche die immer komplexer werdenden elektronischen Bauteile in ihrer Funktion beeinträchtigen können. Daher ist es erforderlich, die elektronischen Geräte einerseits gegenüber elektromagnetischen Störeinflüssen abzuschirmen und andererseits zu verhindern, dass die Geräte selbst ungehindert elektromagnetische Felder abstrahlen.

Es ist daher die Aufgabe der Erfindung, eine Vorrichtung zum Abschirmen eines Schaltschranks vor elektromagnetischer Strahlung derart weiterzuentwickeln, dass diese einerseits eine verbesserte Abschirmung und Schirmdämpfungs-Resonanzminderung aufweist und andererseits eine vereinfachte Montage ermöglicht.

Diese Aufgabe wird durch einen Schaltschrank mit den Merkmalen des Anspruchs 1 gelöst. Der nebengeordnete Anspruch 15 betrifft eine entsprechende Schaltschrankreihe. Die abhängigen Ansprüche betreffen jeweils vorteilhafte Ausführungsformen der Erfindung.

Demgemäß ist vorgesehen, dass die Seitenwand zumindest teilweise mit einer elektromagnetische Wellen-absorbierenden Folie bedeckt ist, wobei die Folie magnetische Partikel aufweist, deren Anteil auf oder jenseits der Perkolationsschwelle liegt.

Bei der vorliegenden Erfindung wird hingegen der Synergieeffekt zwischen elektrisch leitfähigen Partikeln zur Erzeugung der Dämpfungsverlustart Reflexion und dem Einsatz eines Ferroelektrikums zur Erzeugung der Dämpfungsverlustart Absorption ermöglicht, sodass insgesamt eine Erhöhung der Hochfrequenz-Verluste erreicht wird. Insbesondere kann vorgesehen sein, dass die der Gehäuseinnenseite zugewandte Seite der Seitenwand mit der Folie bedeckt ist. Vorzugsweise kann die gesamte Fläche der Seitenwand mit Folie bedeckt sein.

Ferner kann vorgesehen sein, dass die Folie entweder an einer einem Schaltschrankinnenraum zugewandten Seite des Flachteils oder an einer dem Flachteil zugewandten Montageebene eines Rahmengestells des Schaltschranks festgelegt ist.

Dabei kann die Montageebene unter einem Abstand zu dem Flachteil angeordnet sein, vorzugsweise unter einem Abstand von weniger als 5 cm. Der Abstand kann dazu dienen, bei der Montage der Flachteile eine Beschädigung der Folie zu vermeiden. Ferner kann der resultierende Abstand zwischen Flachteil und Folie dazu genutzt werden diesen zur weiteren Erhöhung der Schutzwirkung mit antistatischen oder elektrisch leitfähigen Schaumstoff aufzufüllen. Hierdurch kann zusätzlich sichergestellt werden, dass sich eine lückenlose Abschirmung des Schaltschrankes ergibt.

Die Folie kann eine Polymerfolie sein, welche zur Erhöhung der elektrischen Leitfähig Einlagerung von Füllstoffen aufweist. Diese Füllstoffe können Metalle in Fasern-, Flake- oder Pulverform sein. Insbesondere können diese Füllstoffe Graphit oder Kohlenstoffnanoröhren sein. Alternativ kann die Polymerfolie aus intrinsisch leitfähigem Polymer, beispielsweise Polypyrrol oder Polythiophen sein.

Eine Erhöhung der Leitfähigkeit kann notwendig sein, da die meisten magnetischen Partikel, insbesondere Ferromagnetische Partikel, nicht elektrisch leitfähig sind.

Die Erfindung stellt eine einfache Aus- und/oder Nachrüstung eines Schaltschrankes in Bezug auf eine Elektromagnetische Verträglichkeit (EMV) bereit. Die bisherige Erhöhung der Schirmdämpfung über eine aufwendige punktuelle oder beispielsweise mittels EMV-Dichtungen schlitzfreie Kontaktierung von Flachteilen, Zusatzblechen oder leitenden Folien wie Kupferfolien kann damit entfallen.

Mit zunehmender Konzentration der magnetischen Partikel nimmt die magnetische Leitfähigkeit der Folie zunächst nur schwach zu, mit Erreichen der Perkolationsschwelle erhöht sich die magnetische Leitfähigkeit dann jedoch um einige Größenordnungen. Oberhalb der Perkolationsschwelle ist dann wiederum nur noch eine geringe Zunahme der magnetischen Leitfähigkeit zu beobachten. Daher ist es zum Erreichen bester Funktionalität bei möglichst geringem Magnetpartikeleinsatz vorteilhaft, genau den Bereich der Perkolationsschwelle zu treffen.

Die EMV des Schaltschrankes kann nochmals signifikant gesteigert werden, indem die Folie als Foliensystem eine Mehrlagigkeit, d.h. mehrere Folienlagen, aufweist. Hierzu besteht die Folie aus zumindest zwei Lagen, wobei sich die Lagen mindestens in der Zusammensetzung und/oder im Füllvolumen der eingemischten Partikel und/oder in der Dicke unterscheiden.

Vorzugsweise kann die mehrlagige Folie stetig alternierend zwei Varianten der Lagen aufweisen. Dabei kann eine erste Variante der Lage vor allem hochfrequenzreflektierende Partikel aufweisen und die mindestens eine zweite Variante der Lage kann hochfrequenzabsorbierende Partikel aufweisen. Zwischen den individuellen Lagen der Folie ergibt sich eine Wechselwirkung der Verlustarten, welche in einer gesteigerten Schutzwirkung resultiert. Im Vergleich zu einer Folie, welche eine einzelne Lage mit vergleichbarer Dicke und ähnlichen Magnetpartikeleinsatz aufweist kann die Schirmdämpfung deutlich verbessert werden.

Ferner kann die elektromagnetische Absorption der Folie auf die spezifischen Maße des Schaltschranks und den darin verbauten Bestückungskomponenten maßgeschneidert werden. Durch die verwendeten Werkstoffe und Geometrie weist ein Schaltschrank charakteristische Strukturresonanzfrequenzen auf. In konventionellen Schaltschränken ergeben sich in diesen Frequenzen dramatische Absenkungen der Schirmung und somit eine Reduzierung der EMV.

Durch die geeignete Auswahl der Magnetpartikel lassen sich just in diesen Strukturresonanzfrequenzen Absorptionsresonanzen der Folie erzielen. Diese Absorptionsresonanzen der Folie wirken der Absenkungen der Schirmung entgegen und gewährleisten somit, dass die Schirmdämpfung ununterbrochen für weite Frequenzbereiche erzielt wird. In konventionellen Schaltschränken mit herkömmlichen EMV Folien müsste hingegen zur Vermeidung von Strukturresonanzen entweder die Maße oder der Werkstoff des Schaltschrankes angepasst werden. Dies kann insbesondere dann notwendig sein, wenn Bestückungskomponenten des Schaltschrankes besonders empfindlich in bestimmten Frequenzbändern sind oder selber stark elektromagnetische Strahlung emittieren. Diese empfindliche Einschränkung der Gestaltungsfreiheit lassen sich durch den erfindungsgemäßen Schaltschrank vermeiden. Da die Geometrie des Schaltschrankes nicht angepasst werden muss um eine hohe Schutzwirkung zu erreichen, kann eine größtmögliche Anzahl an Gleichteilen verbaut werden, welche auch Anwendung in Schaltschränken finden, welche keine gesteigerten EMV Eigenschaften aufweisen. Somit kann die Serienfertigung erleichtert werden in dem die Komplexität der einzelnen Arbeitsschritte und Fehlerquellen reduziert werden. Zusätzlich ermöglicht sowie eine modulare Bauweise des Schaltschrankes für eine Vielzahl an unterschiedlichen empfindlichen Bestückungskomponenten ermöglicht werden.

Bei einer Montage der Folie an den Rahmenprofilen des Schaltschrankes kann vorgesehen sein, dass die Folie, ähnlich wie ein Vorhang, parallel zu den Flachteilen an zumindest zwei gegenüberliegenden Rahmenprofilen fixiert und aufgespannt wird. Denkbar ist auch die Fixierung der Folie an vier Rahmenprofilen, welche sich in einer Ebene erstrecken. Diese Art der Montage kann sowohl in Horizontal als auch in Vertikalebenen vorgenommen werden. Die Fixierung der Folie an den Rahmenprofilen kann dabei über umlaufende Klebestreifen auf der Vorder- oder Rückseite der Folie erfolgen. Vorzugsweise wird die Folie jedoch an vorperforierten Stellen mit leitfähigen Verbindungselementen durchstoßen, welche anschließend in den Rahmenprofilen formschlüssig verankert werden.

Ferner kann vorgesehen sein, dass die Rahmenprofile Dichtbleche zur Aufnahme der Folie aufweisen, um hierdurch eine besonders einfache und weniger fehleranfällige Montage zu ermöglichen.

Die Fixierung der Folie kann dabei ohne Einschränkung der Schutzwirkung an der dem Schaltschrankinnenraum zugewandten Seite des Rahmenprofils und/oder dem Seitenteil zugewandten Seite des Raumprofils ausgebildet sein. Alternativ oder zusätzlich kann die Folie, mindestens eine Folienlage oder die gesamte Folie aus mehreren Folienlagen an einer Außenseite des Rahmengestells montiert sein, beispielsweise an einer in Bezug auf eine Dichtebene in Richtung des Schaltschrankinnenraums nach hinten versetzten Montageebene.

Vorteilhaft ist hierbei, dass die Montage deutlich einfacher, schneller und weniger fehleranfällig von statten geht als dies beim Bekleben der Flachteile mit der Folie der Fall wäre. Auch ist vorteilhaft, dass sich auf diese Weise die Bauelemente des Schaltschrankes nicht grundsätzlich von denen eines Schaltschrankes ohne Folie unterscheiden. Somit kann auf die Bauteile konventioneller Schaltschränke zurückgegriffen bzw. die Anzahl an Gleichteilen in der Produktion erhöht werden. Auch kann durch die Montage der Folie an den Rahmenprofilen ältere Schaltschränke, welche keine oder nur unzureichend absorbierende Folie aufweisen, nachgerüstet werden.

Darüber hinaus kann der Schaltschrank eine mit der Folie bedeckte Innenausbaukomponente aufweisen, beispielsweise ein Montagechassis, welche über ein von einem Rahmengestell des Schaltschranks gebildetes zweidimensionales Lochraster mit einem konstanten Rastermaß am Rahmengestell montiert ist. Hierdurch lässt sich die Schutzwirkung in Unterbereichen des Schaltschrankes, welche besonders empfindliche oder stark Strahlung emittierende Bestückungskomponenten aufweisen, abermals erhöhen.

Der Schaltschrank kann besonders empfindliche oder stark elektromagnetische Strahlung emittierende Bestückungskomponenten aufweisen, welche zusätzlich geschützt oder abgeschirmt werden müssen. Hierzu kann zumindest ein Flachteil einen Montagebereich aufweisen, welcher matrixartig mit mindestens zwei Montagezeilen und mindestens zwei Montagespalten ausgebildet ist. Dabei geben die Montagezeilen und die Montagespalten jeweils ein konstantes Rastermaß vor. In den Montagezeilen und/oder den Montagespalten können vorpräparierte Flachteile, welche mit der elektromagnetischen Strahlung absorbieren Folie bedeckt sind, montiert werden. Die vorpräparieren Flachteile sind dabei so dimensioniert, dass deren an den Montagebereich angrenzendes Längenmaß einem ganzzahligen vielfachen des Rastermaßes entspricht.

Infolge der matrixartigen Untergliederung des Montagebereichs ist eine individuelle und modulare Gestaltung von zusätzlichen Schutzbereichen innerhalb des Schaltschrankes möglich. Dabei können die einzelnen vorpräparierten Flachteile in den durch das Rastermaß vorgegebenen Feldern beliebig angeordnet werden. Durch die Dimensionierung der vorpräparierten Flachteile lässt sich der Montagebereich lückenlos ausfüllen. Somit können die Schutzbereiche baukastenartig auf die Geometrie der elektrischen Bestückungskomponenten des Schaltschrankes angepasst werden.

Das Rastermaß kann dabei vorzugsweise 25 mm entsprechen.

Die vorpräparierten Flachteile können dabei Folien mit unterschiedlichen magnetischen Partikeln aufweisen. Auf diese Weise kann die Absorption von elektromagnetischer Strahlung lokal im Schaltschrank auf bestimmte Frequenzbänder eingestellt werden, wodurch der Magnetartikeleinsatz und Kosten minimiert werden.

Auch kann vorgesehen sein, dass der Montagebereich zu einem späteren Zeitpunkt, beispielsweise bei einer Neubestückung des Schaltschrankes mit Komponenten welche anders dimensioniert sind oder andere EMV Toleranzen aufweisen, schnell und kostengünstig angepasst werden kann.

Vorzugsweise weisen die vorpräparieren Flachteile Klemmelemente auf, mit welchen diese in der Montageposition dichtend verspannt werden.

Die Folie kann beispielsweise als Nachrüstkit mit auf die Gehäuseinnenseiten zugeschnittenen Folienstücken ausgebildet sein. Die Gehäuseinnenseite kann dabei zwei Seitenwandelemente, eine Rückwand, ein Dachelement, ein Bodenelement sowie ein Türelement umfassen. Dabei können Folienabschnitte beispielsweise für einzelne separate Gehäuseinnenwandelemente vorgesehen sein. Es können jedoch auch Folienabschnitte so bemessen sein, dass diese an zwei benachbarten Gehäuseinnenelementen angebracht werden können. Beispielsweise kann die an die Scharnierseite der Tür angrenzende Seitenwand einen gemeinsamen Folienabschnitt mit der Tür aufweisen oder die Rückwand einen gemeinsamen Folienabschnitt mit dem Dachelement oder dem Bodenelement oder beiden Elementen aufweist. Es ist beispielsweise denkbar, dass sich die Folie einteilig ausgehend von einer ersten der beiden äußeren Vertikalebenen erstreckt, von dort um 90° in die Horizontalebene übergeleitet und sich weiterhin über eine weitere 90°-Umlenkung einteilig bis in die gegenüberliegende äußere Vertikalebene erstreckt, so dass von derselben Folie drei Außenseiten des Schaltschranks gebildet sind, nämlich die beiden gegenüberliegenden Seitenwände in den gegenüberliegenden äußeren Vertikalebenen und beispielsweise ein Dachelement des Schaltschranks, welches sich in der Horizontalebene befindet. Die Folie kann insbesondere einteilig von einer ersten der äußeren Vertikalebenen über eine Horizontalebene des Schaltschranks in eine zweite, der ersten gegenüberliegende äußere Vertikalebene fortgeführt sein. Weiterhin kann das Nachrüstkit aus einem einzelnen vorkonfektionierten Folienabschnitt bestehen, welcher zusammenhängend zum Verkleiden aller oben genannten Wandabschnitte vorgesehen ist. Zwischen unterschiedlichen Wandabschnitten zugeordneten Folienabschnitten kann die Umfaltkante gekennzeichnet oder vorgeprägt sein. Die einzelnen Folienabschnitte können jeweils eine Kennzeichnung aufweisen, welche die jeweils zugeordnete Wand angibt. Alternativ kann das Nachrüstkit als Rollenmaterial bereitgestellt sein, so dass dieses bei Verwendung individuell auf die jeweilige Schaltschrankgeometrie zugeschnitten werden kann. Die Rollenbreite kann dabei vorteilhaft der Breite des breitesten Innenwandelements des Schaltschranks entsprechen.

Insbesondere kann die Folie eine Polymergrünfolie sein, bei der der Anteil magnetischer Partikel mindestens 5 Vol-% betragen kann.

Das Polymer der Folie kann ein Polyolefin sein oder aufweisen.

Die magnetischen Partikel der Folie können hartmagnetische Ferritpartikel, insbesondere Strontiumferrit, mit Partikelgrößen von 0,1 bis 250 µm aufweisen.

Die magnetischen Partikel können ferner weichmagnetische Ferrit Partikel, insbesondere Mangan-Zink-Ferrit mit Partikelgrößen von 0,1 bis 250 µm aufweisen.

Ferner können die magnetischen Partikel Eisen mit Partikelgrößen von 0,1 bis 250 µm aufweisen.

Die Folie kann eine Dicke von 1 mm bis 3 mm, bevorzugt von 1,7 mm bis 2 mm aufweisen.

Bei einer Bereitstellung der Folie als Rollenmaterial kann diese eine Breite von 25 cm bis 30 cm, bevorzugt 28 cm, aufweisen. Alternativ kann die Breite der Folie der Breite der breitesten Schaltschrankwand entsprechen.

Bei dem Schaltschrank können zwei in gegenüberliegenden äußeren Vertikalebenen angeordnete und sich gegenüberliegende Seitenwände des Schaltschranks zumindest teilweise mit einer Folie eines Nachrüstkits nach den Ansprüchen 1 bis 11 bedeckt sein. Vorzugsweise können die gesamten Flächen der Seitenwände mit Folie bedeckt sein.

Ferner kann bei dem Schaltschrank die Folie einteilig von einer ersten der äußeren Vertikalebenen über eine Horizontalebene des Schaltschranks in eine zweite, der ersten gegenüberliegende der äußeren Vertikalebenen fortgeführt sein.

Ferner kann bei dem Schaltschrank die Folie einteilig von einer ersten Horizontalebene des Schaltschranks über eine Vertikalebene in eine zweite, der ersten gegenüberliegende Horizontalebene fortgeführt ist. Die gegenüberliegenden Horizontalebenen können beispielsweise das Bodenelement und das Dachelement sein.

Außerdem wird eine Schaltschrankreihe aus mindestens zwei aneinandergrenzenden Schaltschränken beansprucht, wobei mindestens eine sich zwischen den Schaltschränken befindende Seitenwand zumindest teilweise mit einer Folie nach den Ansprüchen 1 bis 15 bedeckt sein kann. In der Anreihsituation kann außerdem vorgesehen, sein, dass zwischen zwei aneinandergrenzenden Schaltschränken nur eine Seitenwand vorgesehen ist, das heißt, dass nur an einem der beiden Schaltschränke eine Seitenwand montiert ist. Dabei kann insbesondere vorgesehen sein, dass diese Seitenwand an ihrer Innenseite und an ihrer Außenseite mit einer Folie nach den Ansprüchen 1 bis 14verkleidet ist, so dass eine elektromagnetische Abschirmung beider Innenräume beider benachbarter Schaltschränke erfolgen kann. Vorteilhaft ist dabei, dass durch Verzicht auf jeweils eine Seitenwand zwischen zwei Schaltschränken insbesondere bei groß dimensionierten Schaltschrankanordnungen eine erhebliche Platzeinsparung bei gleichzeitig wirkungsvoller elektromagnetischer Abschirmung jedes Schaltschranks der Schaltschrankreihe erzielt werden kann.

Weitere Einzelheiten der Erfindung werden anhand der nachstehenden Figuren erläutert. Dabei zeigt:
- Fig. 1: einen Schaltschrank gemäß dem Stand der Technik in perspektivischer Darstellung;
- Fig. 2: einen nicht zur beanspruchten Erfindung gehörenden mit Strontiumferrit/Mangan-Zinkferrit/Polyolefin-Folie ausgekleideten Schaltschrank;
- Fig. 3: einen nicht zur beanspruchten Erfindung gehörenden mit Eisen/Polyolefin-Folie ausgekleideten Schaltschrank;
- Fig. 4: eine in einem Schaltschrank vorgesehene Befestigungsanordnung zum Befestigen einer nicht zur beanspruchten Erfindung gehörenden Hochfrequenz-absorbierenden Folie in dem Schaltschrank;
- Fig. 5: eine in einem Schaltschrank vorgesehene Befestigungsanordnung zum Befestigen einer nicht zur beanspruchten Erfindung gehörenden absorbierenden Folie an den Rahmenprofilen des Schaltschrankes;
- Fig. 6: eine perspektivische Darstellung einer im Schaltschrank vorgesehenen Befestigungsanordnung zum Befestigen einer nicht zur beanspruchten Erfindung gehörenden absorbierenden Folie an den Rahmenprofilen des Schaltschrankes.
- Fig. 7: eine in einem Schaltschrank vorgesehene Befestigungsanordnung zum Befestigen einer mit Folie mit zwei Lagen.

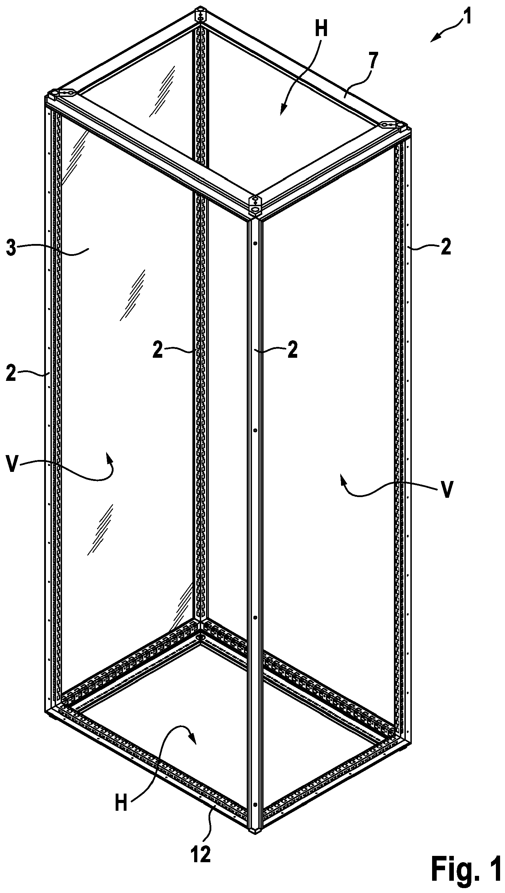

Figur 1 zeigt einen Schaltschrank 1 gemäß dem Stand der Technik. Ein derartiger Schaltschrank ist beispielsweise in der DE 10 2015 121193 B4 beschrieben. Der Schaltschrank 1 weist ein Rahmengestell auf, welches aus vier vertikalen Rahmenprofilen 2, einem Dachelement 7 und einer Bodenbaugruppe 12 aufgebaut ist. Das Dachelement 7 und die Bodenbaugruppe 12 sind im Wesentlichen rechteckig ausgebildet und in ihren Ecken über jeweils eines der vertikalen Rahmenprofile 2 parallel voneinander beabstandet miteinander verbunden. Eine Seitenwand 3 des Schaltschranks 1 ist als ein Flachteil ausgebildet, welches beispielsweise ein gekantetes Blechformteil sein kann. Die Seitenwand 3 ist in der Vertikalebene V an zwei vertikalen Rahmenprofilen 2 sowie der Bodenbaugruppe 12 und dem Dachelement 7 festgelegt. Wenn die Seitenwand 3 des Schaltschranks 1 als Blechformteil ausgebildet ist, weist sie zwar eine hervorragende EMV-Abschirmung auf. In sicherheitsrelevanten Bereichen oder beim Einsatz besonders störempfindlicher elektronischer Geräte kann vor dem Hintergrund stetig steigender Frequenzen jedoch eine zusätzliche Abschirmung notwendig sein. Besonders von Interesse ist dabei das Nachrüsten bereits installierter Schaltschränke mit Schirmeinrichtungen, um ein Ersetzen des gesamten Schaltschranks zu vermeiden. Ferner weist die Seitenwand 3 mit einer Materialstärke von beispielsweise 1,5 mm jedoch eine erhebliche Aufbauhöhe auf, welche die Anreihung identischer der in Figur 1 gezeigten Schaltschränke erschwert.

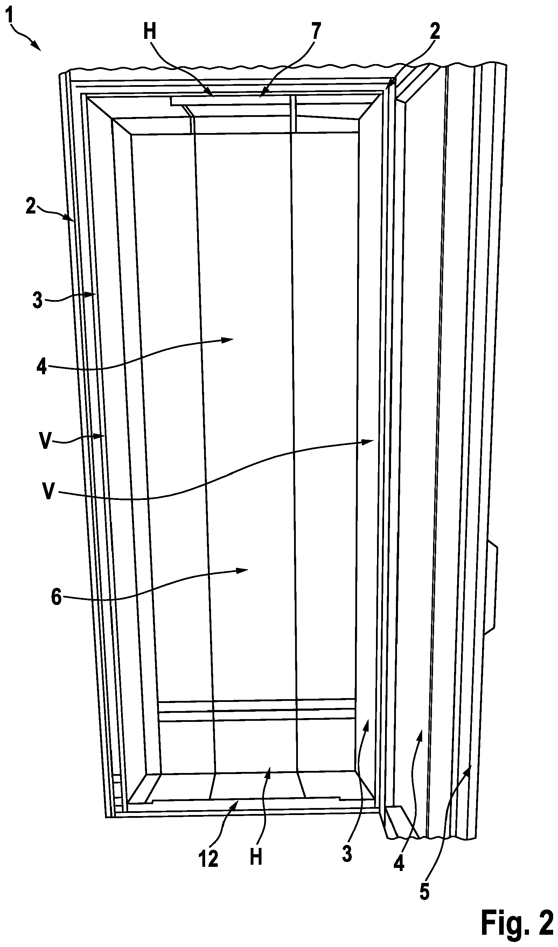

Diese Problematik kann durch die in Figur 2 gezeigte beispielhafte Ausführungsform eines Nachrüstkits beziehungsweise Schaltschranks 1 gelöst werden. Demgemäß ist vorgesehen, dass in mindestens einer der Vertikalebenen V des Schaltschranks 1 eine Seitenwand 3 angeordnet ist, die zumindest teilweise von einer Folie bedeckt ist, welche magnetische Partikel mit einem Partikelanteil auf oder jenseits der Perkolationsschwelle enthält. Vorzugsweise ist die Seitenwand 3 in wesentlichen Teilen mit einer derartigen Folie 4 verkleidet. Insbesondere kann vorgesehen sein, dass die Seitenwand 3, zumindest insoweit wie sie in der Vertikalebene V angeordnet ist, vollständig von einer solchen Folie bedeckt ist, wobei sie allenfalls noch im Randbereich, zur Bereitstellung von Befestigungsmitteln frei von Folie sein kann.

Konkret ist der Schaltschrank 1 in Figur 2 mit Folienbahnen einer Folie 4 ausgekleidet, welche eine Polymergrünfolie aufweisend Polyolefinpolymer mit einem Anteil magnetischer Partikel mehr als 5 Vol-% ist, wobei die magnetischen Partikel hartmagnetisches Ferrit und weichmagnetisches Ferrit mit Partikelgrößen von 0,1 bis 250 µm aufweist. Die Foliendicke beträgt mindestens 0,1 mm und die Breite der verwendeten Folienbahnen 28 cm. Verkleidet sind sämtliche Wandabschnitte des Gehäuseinnenraums, also die Seitenwände 3, die Rückwand 6, die Türinnenseite 5 sowie das Dachelement 7 und das Bodenelement 12. Es ist zu erkennen, dass die Folienbahnen zum Erzielen einer optimalen Schirmwirkung an ihren Rändern leicht überlappend im Schaltschrank angeordnet sind. Ferner ist zu erkennen, dass die Länge der Folienbahnen so gewählt ist, dass diese zusammenhängend das Bodenelement 12, die Rückwand 6 sowie das Dachelement 7 bedecken und in den Eckbereichen jeweils um 90° gefaltet sind. Eine Folienbahn erstreckt sich dabei über die Vertikalebene V der Rückwand 6 von der Horizontalebene H des Bodenelements 12 zur Horizontalebene H des Dachelements 7. Auch die in den Schaltschrankinnenraum hineinragenden vertikalen Rahmenprofile 2 sind von Folie 4 bedeckt, so dass eine optimale Schirmdämpfungs-Resonanzminderung erreicht werden kann. Bei Messungen der Schirmdämpfung nach VG 95373/T15, "Elektromagnetische Verträglichkeit (EMV) - Elektromagnetische Verträglichkeit von Geräten - Teil 15: Prüfverfahren für Kopplungen und Schirmungen", im Frequenzbereich von 9 kHz bis 2000 MHz hat sich herausgestellt, dass unter Verwendung der in Figur 2 gezeigten Folie gerade im Bereich von 30 MHz bis 2000 MHz sehr gute Verbesserungen der Schirmdämpfung von bis zu 20 dB erzielt wurden.

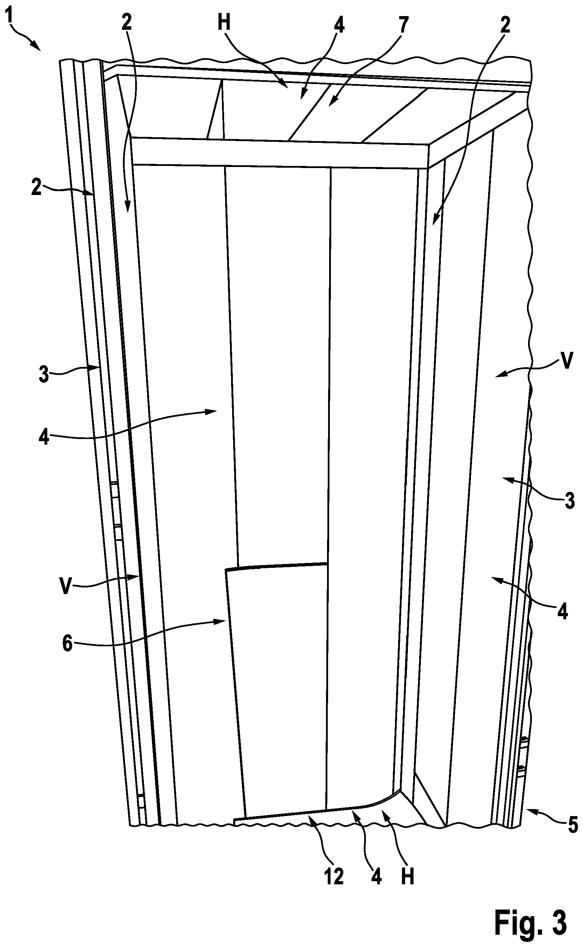

Figur 3 zeigt einen Schaltschrank 1, welcher mit einer Eisenpartikel aufweisenden Polymerfolie ausgekleidet ist Die Foliendicke der in Figur 3 verwendeten Folie beträgt mindestens 0,1 mm bei einer Folienbreite von 28 cm. Bei Messungen der Schirmdämpfung nach VG 95373/T15, "Elektromagnetische Verträglichkeit (EMV) - Elektromagnetische Verträglichkeit von Geräten - Teil 15: Prüfverfahren für Kopplungen und Schirmungen", im Frequenzbereich von 9 kHz bis 2000 MHz hat sich herausgestellt, dass unter Verwendung der in Figur 3 gezeigten Folie gerade im Bereich bis 30 MHz herausragende Verbesserungen der Schirmdämpfung von bis zu 30 dB erzielt wurden. Es ist denkbar, zur Abschirmung des Schaltschranks 1 über einen möglichst großen Frequenzbereich beide Folienarten aus Figur 2 und Figur 3 miteinander zu kombinieren. Dies kann durch Verwendung beider Folien im selben Schrank oder durch Mischen aller magnetischer Partikel in einen kombinierten Folientyp vorgenommen werden.

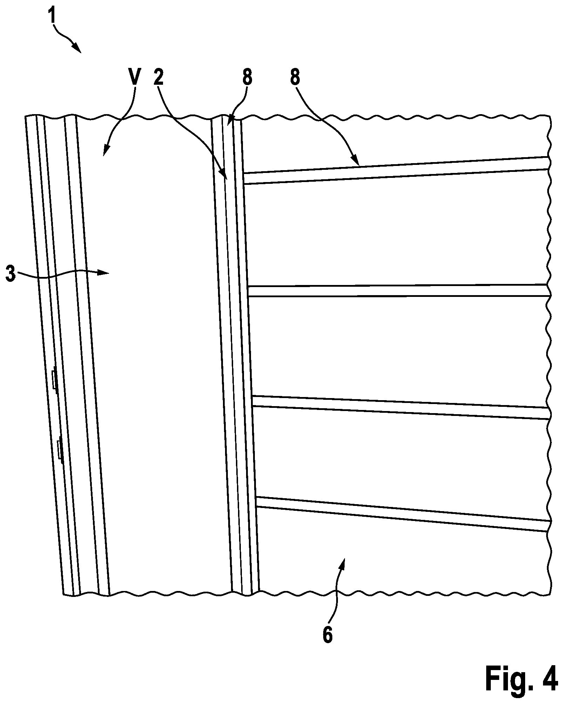

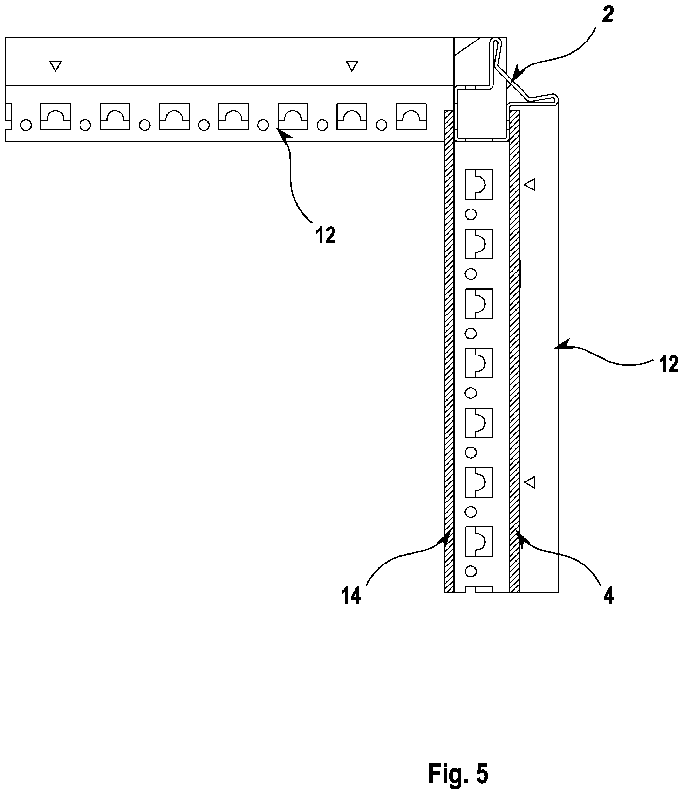

Figur 4 zeigt einen Schaltschrank 1, welcher mit Befestigungsmitteln 8 versehen ist, welche zum Befestigen der Folie 4 im Gehäuseinnenraum dienen. Diese können wir dargestellt doppelseitige Klebestreifen umfassen, welche in beabstandeten Bahnen auf die Wände und auf die in den Gehäuseinnenraum ragenden Rahmenprofile aufgeklebt sind. Alternativ kann vorgesehen sein, dass das als Rollenmaterial oder als fertiger Zuschnitt bereitgestellte Nachrüstkit rückseitig mit Kleber oder Klebestreifen versehen ist, welcher mit einer abziehbaren nichtklebenden Schutzfolie bedeckt ist. Dadurch kann das Nachrüstkit besonders einfach und ohne vorherige Präparierung des Schaltschranks eingeklebt werden. Figur 5 zeigt eine Draufsicht eines Ausschnitts des Rahmengestells eines Schaltschrankes 1 vor Montage der Seitenwände 3. Eine Folien 4 ist mittels doppelseitiger Klebestreifen an der innenraumabgewandten Seite der horizontalen Rahmenprofile 2 vorhangmäßig befestigt. In einem sukzessiven Montageschritt wird eine Seitenwand 3 (nicht dargestellt) parallel zu dem Folienzuschnitt 4 an dem Rahmengestell angebracht, wobei eine Montagenut der Seitenwand 3 über den elliptisch geformten Vorsprung des Rahmenprofils 2 gestülpt wird, welcher rechtwinklig zur Montageebene steht. Durch den Kraftschluss zwischen den Vorsprüngen der Rahmenprofile 2 und den invers gestalteten Montagenuten der Seitenwand 3 wird die Seitenwand 3 auf die Folie gepresst und somit eine dichte Montage begünstigt.

Um die Absorption weiter zu erhöhen, weist der Schaltschrank 1 eine weitere Folie 14 auf. In Bezug auf die Zusammensetzung der Magnetpartikel und die Dimensionen sind Folie 4 und Folie 14 identisch. Die Folie 14 ist in einer Parallelebene zu der Folie 4 und der Seitenwand 3 an der Gehäuseinnenseite zugewandten Seite des Rahmenprofils 2 mittels doppelseitigen Klebeband montiert. Die hiermit erzielte Abschirmung kann notwendig sein, wenn sich an der doppelt abgeschirmten Seite des Schaltschrankes 1 eine starke Quelle für elektromagnetische Strahlung befindet, beispielsweise ein weiterer Schaltschrank mit einer Vielzahl von elektronischen Bestückungskomponenten. Auch bei der Abschirmung von besonders hochfrequenter Strahlung kann eine doppelte Montage der Folie notwendig sein, da selbst sehr kleine Spalte zwischen Folie und Rahmen oder Risse in der Folie in diesem Fall zu einer erheblichen Reduzierung in der Schutzwirkung führen.

Figur 5 zeigt eine Draufsicht eines Ausschnitts des Rahmengestells eines Schaltschrankes 1 vor Montage der Seitenwände 3. Eine Folien 4 ist mittels doppelseitiger Klebestreifen an der innenraumabgewandten Seite der horizontalen Rahmenprofile 2 vorhangmäßig befestigt. In einem sukzessiven Montageschritt wird eine Seitenwand 3 (nicht dargestellt) parallel zu dem Folienzuschnitt 4 an dem Rahmengestell angebracht, wobei eine Montagenut der Seitenwand 3 über den elliptisch geformten Vorsprung des Rahmenprofils 2 gestülpt wird, welcher rechtwinklig zur Montageebene steht. Durch den Kraftschluss zwischen den Vorsprüngen der Rahmenprofile 2 und den invers gestalteten Montagenuten der Seitenwand 3 wird die Seitenwand 3 auf die Folie gepresst und somit eine dichte Montage begünstigt.

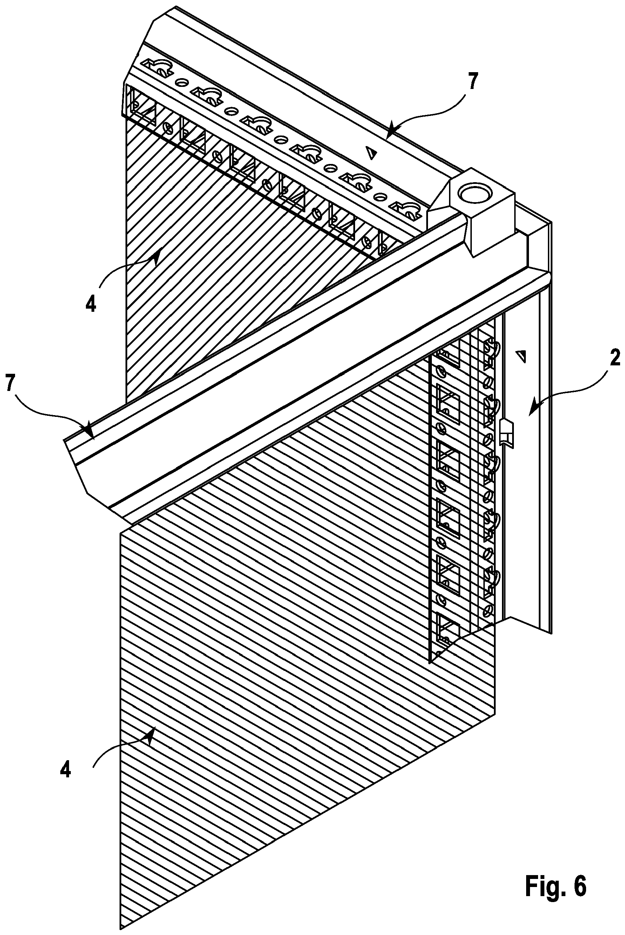

Figur 6 zeigt eine isometrische Darstellung eines Rahmengestells eines Schaltschrankes 1. Ähnlich wie der in der Figur 5 gezeigte Schaltschrank, weist der Schaltschrank 1 eine elektromagnetische Strahlung absorbieren Folie 4 auf, welche in der Vertikalebene V an der innenraumabgewandten Seite des Rahmenprofils 2 montiert ist. Vorteilhaft ist hier, dass weitere Flachteile in den Horizontalebenen H des Schaltschrankes 1 an den Ausbrüchen der Rahmenprofile 2 angebracht werden können, ohne dabei durch die Folie 4 behindert zu werden oder diese während der Montage zu beschädigen. Ferner ist in der Horizontalebene H, welche durch die Rahmenprofile des Dachelementes 7 gebildet wird, die Folie 4 an der innenraumzugewandten Seite des Rahmenprofils montiert um einen lückenlosen Schutz zu erzielen.

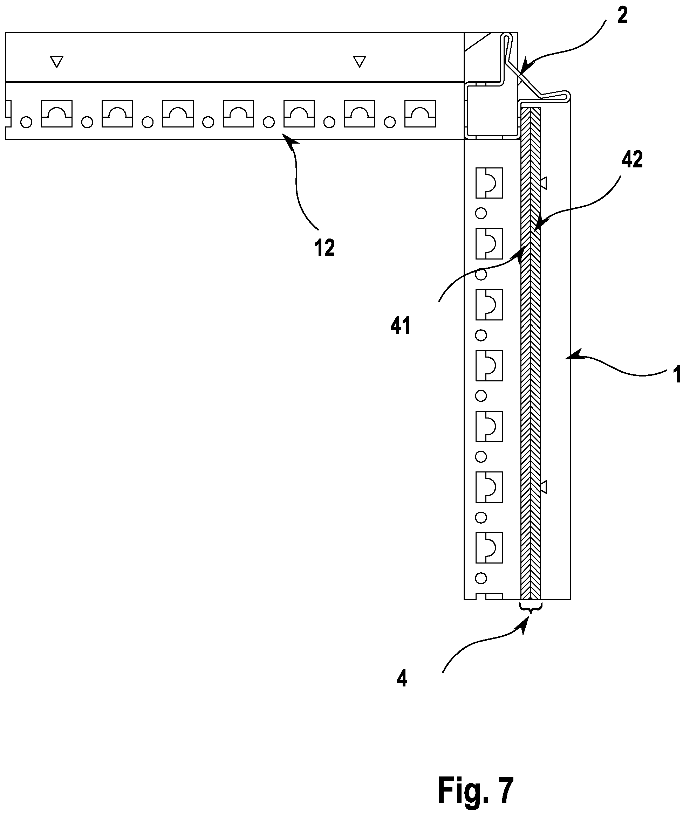

Figur 7 zeigt eine Draufsicht eines Ausschnitts des Schaltschranks 1, welcher zur zusätzlichen Steigerung der EMV eine an innenraumabgewandten Seite des Rahmenprofils vorhangmäßig montierte Folie 4 mit zwei Lagen aufweist. Dabei weist die Folie 4 zwei Lagen mit unterschiedlicher Beladung von magnetischen Partikeln auf. Die gehäuseanliegende erste Lage 41 weist dabei vor allem hart- und weichmagnetische Partikel zur Absorption elektromagnetischer Strahlung auf. Die unmittelbar an der ersten Lage 41 anliegende Lage 42 weist im Gegensatz leitende Partikel zur Reflexion elektromagnetischer Strahlung auf. Die

Mehrlagigkeit ist vorteilhaft, da durch die Wechselwirkung der Lagen Synergien zwischen den Verlustarten genutzt werden und somit die Dämpfungswirkung im gesamten Frequenzbereich gesteigert wird. Darüber hinaus werden die Schwachpunkte in der Schirmdämpfung in Frequenzbereichen der individuellen Lagen durch den Mehrschichtaufbau gemindert. Die Vorteile für die EMV übertreffen dabei den bloßen kumulativen Effekt der einzelnen Lagen deutlich, sodass sich bei vergleichbarer Foliendicke und Magnetpartikeleinsatz durch die Mehrlagigkeit ein besserer Schutz für den Schaltschrank ergibt.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste:

- 1: Schaltschrank
- 2: Rahmenprofil
- 3: Seitenwand
- 4: Folie
- 5: Türinnenseite
- 6: Rückwand
- 7: Dachelement
- 8: Befestigungsmittel
- 12: Bodenelement
- 14: weitere Folie
- 42: weitere Lage
- H: Horizontalebene
- V: Vertikalebene

## Patentansprüche

1. Schaltschrank (1) mit einem im Wesentlichen quaderförmigen Innenraum, welcher von einer Mehrzahl in Horizontal- und Vertikalebenen angeordneten Flachteilen begrenzt wird, wobei zumindest eines der Flachteile auf seiner zum Innenraum weisenden Seite zumindest teilweise mit einer elektromagnetische Wellen absorbierenden Folie (4) bedeckt ist,
**dadurch gekennzeichnet, dass** die Folie (4) magnetische Partikel aufweist, deren Anteil auf oder jenseits der Perkolationsschwelle liegt, wobei die Folie (4) zumindest zwei Lagen aufweist, wobei die Lagen unterschiedliche Zusammensetzungen der magnetischen Partikel aufweisen.

2. Schaltschrank (1) nach Anspruch 1, bei dem die Folie (4) entweder an einer einem Schaltschrankinnenraum zugewandten Seite des Flachteils oder an einer dem Flachteil zugewandten Montageebene eines Rahmengestells des Schaltschranks (1) festgelegt ist.

3. Schaltschrank nach Anspruch 2, bei dem die Montageebene unter einem Abstand zu dem Flachteil angeordnet ist, vorzugsweise unter einem Abstand von weniger als 5 cm.

4. Schaltschrank (1) nach einem der vorangegangenen Ansprüche, wobei die Folie (4) eine Polymergrünfolie ist, wobei die Folie (4) vorzugsweise als Polymer ein Polyolefin aufweist.

5. Schaltschrank (1) nach einem der vorangegangenen Ansprüche, wobei die Folie (4) leitfähige Füllstoffe, vorzugsweise Graphit und/oder Kohlenstoffnanoröhren aufweist.

6. Schaltschrank (1) nach einem der vorangegangenen Ansprüche, wobei die magnetischen Partikel hartmagnetisches Ferrit, insbesondere Strontiumferrit, mit Partikelgrößen von 0,1 bis 250 µm aufweisen.

7. Schaltschrank (1) nach einem der vorangehenden Ansprüche, wobei die magnetischen Partikel weichmagnetisches Ferrit, insbesondere Mangan-Zink-Ferrit, mit Partikelgrößen von 0,1 bis 250 µm aufweisen.

8. Schaltschrank (1) nach einem der vorangehenden Ansprüche, wobei die magnetischen Partikel Eisen mit Partikelgrößen von 0,1 bis 250 µm aufweisen.

9. Schaltschrank (1) nach einem der vorangehenden Ansprüche, wobei die Folie (4) stetig alternierend eine elektromagnetische Wellen absorbierende Lage mit einer ersten Zusammensetzung der magnetischen Partikel und eine elektromagnetische Wellen reflektierende Lage mit einer zweiten, sich von der ersten Zusammensetzung unterscheidenden Zusammensetzung der magnetischen Partikel aufweist.

10. Schaltschrank (1) nach einem der vorangehenden Ansprüche, wobei die magnetischen Partikel Absorptionsresonanzen in den Strukturresonanzfrequenzen des Schaltschrankes (1) aufweisen.

11. Schaltschrank (1) nach einem der vorangehenden Ansprüche, wobei die Folie (4) eine Dicke von 1 mm bis 3 mm, bevorzugt 1,7 mm bis 2 mm und/oder eine Breite von 25 cm bis 30 cm, bevorzugt 28 cm, aufweist.

12. Schaltschrank (1) nach einem der vorangehenden Ansprüche, wobei zumindest eine mit der Folie (4) bedeckte Innenausbaukomponente, vorzugsweise ein Montagechassis, über ein von einem Rahmengestell des Schaltschranks gebildetes zweidimensionales Lochraster mit einem konstanten Rastermaß an dem Rahmengestell montiert ist.

13. Schaltschrank (1) nach einem der vorangehenden Ansprüche, bei dem zwei in gegenüberliegenden äußeren Vertikalebenen (V) angeordnete und sich gegenüberliegende Flachteile (3) des Schaltschranks (1) jeweils zumindest teilweise mit der elektromagnetische Wellen absorbierenden Folie (4) bedeckt sind.

14. Schaltschrank (1) nach Anspruch 13, bei dem die Folie (4) einteilig entweder von einer ersten der äußeren Vertikalebenen (V) über eine Horizontalebene (H) des Schaltschranks (1) in eine zweite, der ersten gegenüberliegende der äußeren Vertikalebenen (V) oder von einer ersten Horizontalebene (H) des Schaltschranks (1) über eine Vertikalebene (V) in eine zweite, der ersten gegenüberliegende Horizontalebene (H) fortgeführt ist.

15. Schaltschrankreihe aus mindestens zwei aneinandergrenzenden Schaltschränken (1) nach einem der vorangegangenen Ansprüche, bei der mindestens eine sich zwischen den Schaltschränken (1) befindende Seiten- oder Trennwand (3) zumindest teilweise mit elektromagnetische Wellen absorbierenden Folie (4) bedeckt ist.

## Claims

1. A switch cabinet (1) having a substantially cuboidal interior space which is limited by a plurality of flat parts arranged in horizontal and vertical planes, at least one of the flat parts being at least partially covered on its side facing the interior space with a foil (4) which absorbs electromagnetic waves,
**characterized in that** the foil (4) comprises magnetic particles whose proportion is at or beyond the percolation threshold, the foil (4) comprising at least two layers, the layers having different compositions of the magnetic particles.

2. The switch cabinet (1) according to claim 1, wherein the foil (4) is fixed either to a side of the flat part facing a switch cabinet interior or to a mounting plane of a frame of the switch cabinet (1) facing the flat part.

3. The switch cabinet according to claim 2, wherein the mounting plane is arranged at a distance from the flat part, preferably at a distance of less than 5 cm.

4. The switch cabinet (1) according to any one of the preceding claims, wherein the foil (4) is a polymer green foil, the foil (4) preferably comprising as polymer a polyolefin.

5. The switch cabinet (1) according to any one of the preceding claims, wherein the foil (4) comprises conductive fillers, preferably graphite and/or carbon nanotubes.

6. The switch cabinet (1) according to any one of the preceding claims, wherein the magnetic particles comprise hard magnetic ferrite, in particular strontium ferrite, with particle sizes of 0.1 to 250 µm.

7. The switch cabinet (1) according to one of the preceding claims, wherein the magnetic particles comprise soft magnetic ferrite, in particular manganese-zinc ferrite, with particle sizes of 0.1 to 250 µm.

8. The switch cabinet (1) according to any one of the preceding claims, wherein the magnetic particles comprise iron having particle sizes of 0.1 to 250 µm.

9. The switch cabinet (1) according to any one of the preceding claims, wherein the foil (4) comprises continuously alternatingly an electromagnetic wave absorbing layer having a first composition of the magnetic particles and an electromagnetic wave reflecting layer having a second composition of the magnetic particles different from the first composition.

10. The switch cabinet (1) according to any one of the preceding claims, wherein the magnetic particles have absorption resonances in the structural resonance frequencies of the switch cabinet (1).

11. The switch cabinet (1) according to any one of the preceding claims, wherein the foil (4) has a thickness of 1 mm to 3 mm, preferably 1.7 mm to 2 mm, and/or a width of 25 cm to 30 cm, preferably 28 cm.

12. The switch cabinet (1) according to one of the preceding claims, wherein at least one interior fitting component covered with the foil (4), preferably a mounting chassis, is mounted on the frame via a two-dimensional hole grid formed by a frame of the switch cabinet with a constant grid dimension.

13. The switch cabinet (1) according to one of the preceding claims, in which two flat parts (3) of the switch cabinet (1) arranged in opposite outer vertical planes (V) and facing each other are each at least partially covered with the electromagnetic wave-absorbing foil (4).

14. The switch cabinet (1) according to claim 13, wherein the foil (4) is continued in one piece either from a first of the outer vertical planes (V) via a horizontal plane (H) of the switch cabinet (1) into a second of the outer vertical planes (V) opposite to the first, or from a first horizontal plane (H) of the switch cabinet (1) via a vertical plane (V) into a second horizontal plane (H) opposite to the first.

15. A switch cabinet row consisting of at least two adjacent switch cabinets (1) according to one of the preceding claims, in which at least one side or partition wall (3) located between the switch cabinets (1) is at least partially covered with electromagnetic wave-absorbing foil (4).

## Revendications

1. Armoire de commande (1) avec un espace interne globalement parallélépipédique, qui est délimité par une pluralité de parties plates disposées dans les plans horizontaux et verticaux, dans lequel au moins une des parties plates est recouverte, sur son côté orienté vers l'espace interne, au moins partiellement avec une feuille (4) absorbant les ondes électromagnétiques,
**caractérisée en ce que** la feuille (4) comprend des particules magnétiques dont une partie se trouve sur ou au-delà du seuil de percolation, dans laquelle la feuille (4) comprend au moins deux couches, dans laquelle les couches présentent des compositions différentes des particules magnétiques.

2. Armoire de commande (1) selon la revendication 1, dans laquelle la feuille (4) est fixée soit à un côté orienté vers un espace interne de l'armoire de commande soit à un plan de montage, orienté vers la partie plate, d'un cadre de l'armoire de commande (1).

3. Armoire de commande (1) selon la revendication 2, dans laquelle le plan de montage est disposée à une certaine distance de la partie plate, de préférence à une distance inférieure à 5 cm.

4. Armoire de commande (1) selon l'une des revendications précédentes, dans laquelle la feuille (4) est une feuille crue de polymère, dans laquelle la feuille (4) comprend de préférence, en tant que polymère, une polyoléfine.

5. Armoire de commande (1) selon l'une des revendications précédentes, dans laquelle la feuille (4) comprend des charges conductrices, de préférence du graphite et/ou des nanotubes de carbone.

6. Armoire de commande (1) selon l'une des revendications précédentes, dans laquelle les particules magnétiques comprennent de la ferrite magnétique dure, plus particulièrement de la ferrite de strontium, avec des tailles de particules de 0,1 à 250 µm.

7. Armoire de commande (1) selon l'une des revendications précédentes, dans laquelle les particules magnétiques comprennent de la ferrite magnétique douce, plus particulièrement de la ferrite de manganèse-zinc, avec des tailles de particules de 0,1 à 250 µm.

8. Armoire de commande (1) selon l'une des revendications précédentes, dans laquelle les particules magnétiques comprennent du fer avec des tailles de particules de 0,1 à 250 µm.

9. Armoire de commande (1) selon l'une des revendications précédentes, dans laquelle la feuille (4) comprend, avec une alternance permanente, une couche absorbant les ondes électromagnétiques avec une première composition de particules magnétiques et une couche réfléchissant les ondes électromagnétiques avec une deuxième composition en particules magnétiques, différente de la première composition en particules magnétiques.

10. Armoire de commande (1) selon l'une des revendications précédentes, dans laquelle les particules magnétiques présentent des résonances d'absorption dans les fréquences de résonances structurelles de l'armoire de commande (1).

11. Armoire de commande (1) selon l'une des revendications précédentes, dans laquelle la feuille (4) présente une épaisseur de 1 mm à 3 mm, de préférence de 1,7 mm à 2 mm et/ou une largeur de 25 cm à 30 cm, de préférence de 28 cm.

12. Armoire de commande (1) selon l'une des revendications précédentes, dans laquelle au moins un composant d'aménagement interne revêtu avec la feuille (4), de préférence un châssis de montage, est monté sur le cadre à l'aide d'une trame de perforation bidimensionnelle, avec une dimension de trame constante, formée par un cadre de l'armoire de commande.

13. Armoire de commande (1) selon l'une des revendications précédentes, dans laquelle deux parties plates (3) de l'armoire de commande (1), disposées sur des plans verticaux externes (V) opposés et se faisant face, sont revêtues chacune au moins partiellement avec la feuille (4) absorbant les ondes électromagnétiques.

14. Armoire de commande (1) selon la revendication 13, dans laquelle la feuille (4) est prolongée d'une seule pièce soit par un premier des plans verticaux externes (V), en passant par un plan horizontal (H) de l'armoire de commande (1), vers un deuxième des plans verticaux externes (V), opposé au premier, soit par un premier plan horizontal (H) de l'armoire de commande (1), en passant par un plan vertical (V), vers un deuxième plan horizontal (H), opposé au premier.

15. Rangée d'armoires de commande constituée d'au moins deux armoires de commandes (1) adjacentes entre elles selon l'une des revendications précédentes, dans laquelle au moins une paroi latérale ou cloison (3) se trouvant entre les armoires de commande (1) est recouverte au moins partiellement d'une feuille (4) absorbant les ondes électromagnétiques.
